(19) **Europäisches Patentamt**
European Patent Office
Office européen des brevets

(11) **EP 1 685 447 B1**

(12) **EUROPÄISCHE PATENTSCHRIFT**

(45) Veröffentlichungstag und Bekanntmachung des Hinweises auf die Patenterteilung:
**11.01.2012 Patentblatt 2012/02**

(21) Anmeldenummer: **04797817.6**

(22) Anmeldetag: **11.11.2004**

(51) Int Cl.:
***G03F 7/36*** (2006.01)    ***G03F 7/033*** (2006.01)

(86) Internationale Anmeldenummer:
**PCT/EP2004/012787**

(87) Internationale Veröffentlichungsnummer:
**WO 2005/050327 (02.06.2005 Gazette 2005/22)**

(54) **VERFAHREN ZUR HERSTELLUNG VON FLEXODRUCKFORMEN DURCH THERMISCHE ENTWICKLUNG**

METHOD FOR PRODUCING FLEXOGRAPHIC PRINTING FORMS BY THERMAL DEVELOPMENT

PROCEDE DE REALISATION DE FORMES FLEXOGRAPHIQUES PAR DEVELOPPEMENT THERMIQUE

(84) Benannte Vertragsstaaten:
**DE FR GB IT**

(30) Priorität: **17.11.2003 DE 10353762**

(43) Veröffentlichungstag der Anmeldung:
**02.08.2006 Patentblatt 2006/31**

(73) Patentinhaber: **Flint Group Germany GmbH**
**70469 Stuttgart (DE)**

(72) Erfinder:
• **HILLER, Margit**
**97753 Karlstadt (DE)**

• **BECKER, Armin**
**67259 Grossniedesheim (DE)**
• **STEBANI, Uwe**
**67592 Flörsheim-Dalsheim (DE)**
• **SCHADEBRODT, Jens**
**55129 Mainz (DE)**

(74) Vertreter: **Isenbruck, Günter**
**Isenbruck Bösl Hörschler LLP**
**Eastsite One**
**Seckenheimer Landstrasse 4**
**68163 Mannheim (DE)**

(56) Entgegenhaltungen:
**EP-A- 0 778 297    WO-A-01/88615**

**Beschreibung**

Die Erfindung betrifft ein Verfahren zur Herstellung von Flexodruckformen durch thermische Entwicklung, bei dem man ein bildweise belichtetes Flexodruckelement durch Erwärmen und Entfernen der erweichten, nicht polymerisierten Anteile der reliefbildenden Schicht entwickelt, wobei das eingesetzte Flexodruckelement ein Styrol-Butadien-Blockcopolymeres im Gemisch mit einem Weichmacher enthält, und wobei der Anteil von Butadien, welches 1,2- verknüpft vorliegt, 15 bis 50 Gew. % bzgl. des Blockcopolymeren beträgt.

Das am weitesten verbreitete Verfahren zur Herstellung von Flexodruckformen umfasst die bildmäßige Belichtung der fotopolymerisierbaren reliefbildenden Schicht mit UV/VIS-Strahlung durch eine fotografisch oder digital erstellte Maske. In einem weiteren Verfahrensschritt wird die belichtete Schicht mit einem geeigneten Lösemittel bzw. Lösemittelgemisch behandelt, wobei die unbelichteten, nicht polymerisierten Bereiche der reliefbildenden Schicht gelöst werden, während die belichteten, polymerisierten Bereiche erhalten bleiben und das Relief der Druckplatte bilden.

Der Auswaschprozess benötigt jedoch eine längere Zeitspanne. Weiterhin werden die polymerisierten Schichtbestandteile zwar nicht gelöst, aber sie quellen gleichwohl im Auswaschmittel. Die Platte muss daher nach dem Auswaschen noch sorgfältig getrocknet werden, bevor sie zum Druck verwendet werden kann. Der Trockenprozess kann mehrere Stunden dauern.

EP-A 525 206 offenbart ein fotoempfindliches Flexodruckelement, welches mindestens 50 Gew. % eines SBS-Blockcopolymers, bei dem die Butadienblöcke einen Vinylgehalt von 20 - 50 % aufweisen, enthält. Es wird nach dem Belichten auf konventionelle Art und Weise durch Auswaschen mittels eines Gemisches aus Tetrachlorethylen/Butanol entwickelt.

Als Alternative zur Entwicklung mittels Lösemitteln ist von US 3,264,103, US 5,175,072, WO 96/14603, WO 01/88615 oder EP-A 1 239 329 die thermische Entwicklung vorgeschlagen worden.

Bei der thermischen Entwicklung wird kein Lösemittel eingesetzt. Statt dessen wird die reliefbildende Schicht nach der bildmäßigen Belichtung mit einem absorbierenden Material in Kontakt gebracht und erwärmt. Bei dem absorbierenden Material kann es sich um ein poröses Vlies, beispielsweise aus Nylon, Polyester, Cellulose oder anorganischen Materialien handeln. Durch das Erwärmen verflüssigen sich die nicht polymerisierten Anteile der reliefbildenden Schicht und werden vom Vlies aufgesogen. Das vollgesogene Vlies wird anschließend entfernt.

Anstelle der Verwendung von absorbierenden Materialien zur Entfernung der verflüssigten Masse ist von WO 01/90818 als Alternative vorgeschlagen worden, das belichtete Flexodruckelement mit einem heißen Luft- oder Flüssigkeitsstrom unter Druck zu behandeln und somit die nicht polymerisierten Anteile zu entfernen.

Zur Durchführung der thermischen Entwicklung geeignete Geräte sind von EP-A 469 735 und WO 01/18604 vorgeschlagen worden und sind unter dem Namen Cyrel® Fast auch kommerziell erhältlich.

Als bevorzugte Materialien für Flexodruckelemente zur thermischen Entwicklung sind von EP-A 468 745 elastomere Polyurethane vorgeschlagen worden. Die Schrift erwähnt, dass auch einige kommerziell erhältliche, zur Entwicklung mit Lösemitteln vorgesehene, Flexodruckelemente prinzipiell zur thermischen Entwicklung geeignet sind.

WO 01/88615 führt aus, dass kommerziell erhältliche, zur Entwicklung mit Lösemitteln vorgesehene, Flexodruckelemente häufig nicht zur thermischen Entwicklung geeignet sind, und schlägt statt dessen Flexodruckelemente vor, deren reliefbildende Schicht bestimmte dynamisch-mechanische Kennwerte aufweist. In den Beispielen von WO 01/88615 wird zur thermischen Entwicklung ein Flexodruckelement eingesetzt, welches 73 Gew. % an Bindemitteln sowie 12 Gew. % eines Polybutadienöles umfasst. Bei den Bindemitteln handelt es sich um eine Mischung zweier verschiedener SIS-Blockcopolymere.

Trotz der prinzipiellen Eignung zur Herstellung von Flexodruckformen hat die thermische Entwicklung die Entwicklung mittels Lösemitteln bislang keineswegs ersetzt. Insbesondere die Herstellung von hochauflösenden Platten in gleichbleibender Qualität und die Herstellung von Platten mit großen Relieftiefen bereiten bislang immer noch Probleme.

Wesentliche Qualitätskriterien für eine qualitativ hochwertige Flexodruckplatte sind Gleichmäßigkeit und Sauberkeit des Reliefuntergrundes sowie die Schärfe von Elementrändern, die präzise ausgebildet und frei von Schmelzrückständen sein sollten. Hierzu ist es erforderlich, dass das nicht polymerisierte Material möglichst gut verflüssigbar ist, um eine effiziente und vollständige Entfernung zu ermöglichen. Auf dem Druckrelief verbleibende Ablagerungen führen zu verringerter Auflösung und/oder zu einem unsauberen, qualitativ minderwertigen Druckbild.

Hier befindet sich der Fachmann in einer typischen Scherensituation. Einerseits wird die gute Verflüssigung des zu entfernenden Materials naturgemäß durch höhere Temperaturen begünstigt. Je dünnflüssiger, desto besser und desto schneller wird das verflüssigte polymere Material vom Vlies aufgesogen. Nachteiligerweise leidet mit zunehmender Temperatur aber die Dimensionsstabilität der Trägerfolie. Weiterhin ist die Druckplatte im Zuge des Andrückens oder Anpressens des Vlieses auch einer mechanischen Belastung ausgesetzt. Die Kombination von hoher Temperatur und mechanischer Belastung kann das Relief erheblich beschädigen. Beispielsweise können Reliefelemente umgeknickt oder sogar vollständig abgerissen werden, wenn sie nicht gut genug im Untergrund versockelt sind. Dieser Effekt macht sich naturgemäß bei den feinen Reliefelementen am stärksten bemerkbar. Häufig weisen Flexodruckelemente bei thermischer Entwicklung einen negativen Belichtungsspielraum auf, während der Belichtungsspielraum bei der Entwicklung mittels Lösemitteln noch positiv ist. Ein negativer Belichtungsspielraum ist in der Praxis unerwünscht.

Flexodruckelemente auf Basis von SIS-Blockcopolymeren sind kommerziell erhältlich. Sie sind jedoch häufig vergleichsweise weich. Flexodruckplatten für Anwendungen, bei denen die Reliefschicht eine höhere Härte aufweisen muss, lassen sich mit SIS-Bindemitteln nur schlecht erhalten. Weiterhin weisen Flexodruckelemente auf Basis von SIS-Polymeren eine hohe Oberflächenklebrigkeit auf, und benötigen zur Vermeidung von Rissbildung durch Ozon, das in der Nähe von UV-Strahlern beim Härten von UV-Druckfarben auftritt, als Zusatz mindestens ein Ozonschutzmittel. Als Ozonschutzmittel werden beispielsweise paraffinische Wachse eingesetzt, welche jedoch die Farbübertragung mit Wasserfarben verschlechtern.

Flexodruckformen mit SBS-Blockcopolymeren als Bindemittel sind für viele Anwendungen besser geeignet. Sie sind weniger klebrig, benötigen keine UV-Schutzmittel und Reliefschichten größerer Härte lassen sich leicht erhalten. Übliche Flexodruckelemente auf Basis von SBS-Blockcopolymeren lassen sich bislang aber noch nicht mit zufriedenstellendem Ergebnis thermisch entwickeln. So weisen beispielsweise Flexodruckelemente mit üblichen SBS-Blockcopolymeren beim thermischen Entwickeln einen negativen Belichtungsspielraum auf.

EP-A-778 297 offenbart ein Verfahren zur Herstellung von Flexodruckformen durch thermische Entwicklung mittels einer Entwicklerflüssigkeit, bei dem man als Ausgangsmaterial ein fotopolymerisierbares Flexodruckelement einsetzt, welches übereinander angeordnet umfasst:

- einen dimensionsstabilen Träger,
- eine fotopolymerisierbare reliefbildende Schicht, umfassend ein SBS-Blockcopolymer als Bindemittel, ethylenisch ungesättigte Monomere, einen Weichmacher und einen Fotoinitiator,
und das Verfahren die folgenden Schritte umfasst:

    (a) bildweises Belichten der fotopolymerisierbaren reliefbildenden Schicht mittels aktinischer Strahlung,
    (b) Erwärmen des belichteten Flexodruckelementes auf eine Temperatur von 50°C,
    (c) Entfernen der erweichten, nicht polymerisierten Anteile der relief bildenden Schicht unter Ausbildung eines Druckreliefs.

Aufgabe der Erfindung war es, ein Verfahren zur Herstellung von Flexodruckformen mittels thermischer Entwicklung bereit zu stellen, bei dem Flexodruckformen auf Basis von SBS-Kautschuken erhalten werden. Insbesondere sollten die eingesetzten Flexodruckelemente auf SBS-Basis keinen negativen Belichtungsspielraum aufweisen und nach der thermischen Entwicklung die Ausbildung scharfkantiger Elemente ohne zurückbleibende Schmelzreste an den Elementrändern ermöglichen.

Dementsprechend wurde ein Verfahren zur Herstellung von Flexodruckformen durch thermische Entwicklung gefunden, bei dem man als Ausgangsmaterial ein fotopolymerisierbares Flexodruckelement einsetzt, welches übereinander angeordnet mindestens umfasst

• einen dimensionsstabilen Träger,

• mindestens eine fotopolymerisierbare reliefbildende Schicht, mindestens umfassend mindestens ein elastomeres Bindemittel, ethylenisch ungesättigte Monomere, Weichmacher und Fotoinitiator,
und das Verfahren mindestens die folgenden Schritte umfasst:

    (a) bildweises Belichten der fotopolymerisierbaren reliefbildenden Schicht mittels aktinischer Strahlung,

    (b) Erwärmen des belichteten Flexodruckelementes auf eine Temperatur von 40 bis 200°C,

    (c) Entfernen der erweichten, nicht polymerisierten Anteile der reliefbildenden Schicht unter Ausbildung eines Druckreliefs,

und es sich bei dem elastomeren Bindemittel um mindestens ein Styrol-Butadien-Blockcopolymeres mit einem Molekulargewicht $M_w$ von 80 000 bis 250 000 g/mol und einem Styrolgehalt von 15 bis 35 Gew. % bzgl. des Bindemittels handelt, wobei der Anteil von Butadien, welches 1,2-verknüpft vorliegt, mindestens 15 Gew. % bzgl. des Bindemittels beträgt, und die Menge des Styrol-Butadien-Blockcopolymeren 35 bis 50 Gew. % und die des Weichmachers 25 bis 50 Gew. % jeweils bezüglich der Summe aller Komponenten der reliefbildenden Schicht beträgt.

Überraschenderweise wurde gefunden, dass mit dem erfindungsgemäßen Verfahren Flexodruckformen hervorragender Qualität erhalten werden. Das nicht polymerisierte Material lässt sich thermisch hervorragend entfernen, ohne dass Reste auf den Reliefelementen zurückbleiben oder Reliefelemente beschädigt werden. Selbst feine Raster bei Rasterweiten von 60 Ucm werden fehlerfrei ausgebildet. Die Temperaturbelastung des Elementes im Zuge des Verfahrens ist so niedrig, dass auch bei Verwendung üblicher PET-Folien gute Resultate erzielt werden. Der Belichtungsspielraum der erfindungsgemäß eingesetzten Flexodruckelemente ist nicht negativ.

Zu der Erfindung ist im Einzelnen das Folgende auszuführen:

Beispiele geeigneter dimensionsstabiler Träger für das als Ausgangsmaterial für das Verfahren eingesetzten fotopolymerisierbaren Flexodruckelement sind Platten, Folien sowie konische und zylindrische Röhren (Sleeves) aus Metallen wie Stahl, Aluminium, Kupfer oder Nickel oder aus Kunststoffen wie Polyethylenterephthalat (PET), Polyethylennaphthalat (PEN), Polybutylenterephthalat, Polyamid, Polycarbonat, gegebenenfalls auch Gewebe und Vliese, wie Glasfasergewebe sowie Verbundmaterialien, z.B. aus Glasfasern und Kunststoffen. Als dimensionsstabile Träger kommen vor allem dimensionsstabile Trägerfolien wie beispielsweise Polyesterfolien, insbesondere PET- oder PEN-Folien oder flexible metallische Träger, wie dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht.

Das Flexodruckelement umfasst weiterhin mindestens eine fotopolymerisierbare, reliefbildende Schicht. Die fotopolymerisierbare reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten und/oder elastische Unterschichten.

Die fotopolymerisierbare reliefbildende Schicht umfasst mindestens ein elastomeres Bindemittel, ethylenisch ungesättigte Monomere, einen Weichmacher, einen Fotoinitiator oder ein Fotoinitiatorsystem sowie optional weitere Komponenten.

Bei den erfindungsgemäß eingesetzten elastomeren Bindemitteln handelt es sich um ein Styrol-Butadien-Blockcopolymere. Hierbei kann es sich um Zweiblockcopolymere, Dreiblockcopolymere oder um Multiblockcopolymere handeln, bei denen alternierend jeweils mehrere Styrol- und Butadienblöcke aufeinander folgen. Es kann sich sowohl um lineare, verzweigte oder auch sternförmige Blockcopolymere handeln. Bevorzugt handelt es sich bei den erfindungsgemäß eingesetzten Blockcopolymeren um StyrolButadien-Styrol-Dreiblockcopolymere. SBS-Dreiblockcopolymere, insbesondere kommerzielle Produkte, können herstellungsbedingt noch kleinere Anteile von Zweiblockcopolymeren umfassen. Dies soll im Begriff Dreiblockcopolymer mit umfasst sein.

Die Butadieneinheiten in den Butadien-Blöcken weisen sowohl 1,4-verknüpfte Einheiten wie 1,2-verknüpfte Einheiten auf. Der Anteil von Butadien-Einheiten, welche 1,2-verknüpft vorliegen, beträgt zumindest 15 Gew. % bzgl. des Bindemittels. Bei geringeren Mengen wird in aller Regel keine befriedigende thermische Entwicklung mehr erreicht und insbesondere sind die Belichtungsspielräume des Flexodruckelementes unbefriedigend. Im Prinzip können alle Butadieneinheiten 1,2-verknüpft sein. Es ist aber aus praktischen Gründen schwierig, ausschließlich 1,2-verknüpfte Blöcke zu erhalten. Bevorzugt beträgt der Anteil 1,2-verknüpfter Einheiten mindestens 20 Gew. %.

Das gewichtsmittlere Molekulargewicht $M_w$ der Styrol-Butadien-Blockcopolymere beträgt 80 000 bis 250 000 g/mol und bevorzugt 120 000 bis 180 000 g/mol. Bei höheren Molekulargewichten wird in aller Regel keine gute thermische Entwickelbarkeit mehr erreicht, und bei niedrigeren Molekulargewichten werden keine Reliefschichten mit guten Druckeigenschaften mehr erhalten. Der Styrol-Gehalt des Bindemittels beträgt 15 bis 35 Gew. % bezüglich des Bindemittels, bevorzugt 20 bis 35 Gew. % und besonders bevorzugt 25 bis 35 Gew. %.

Der hohe Gehalt an 1,2-verknüpften Polybutadieneinheiten im Bindemittel gewährleistet, dass der Belichtungsspielraum nicht negativ ist. Setzt man ein Styrol-Butadien-Blockcopolymeres vergleichbaren Molekulargewichtes und Styrolgehaltes jedoch mit einem geringeren Gehalt an 1,2- verknüpften Polybutadieneinheitenein, so erhält man Flexodruckelemente mit negativem Belichtungsspielraum. Hieraus lassen sich daher keine oder zumindest keine hochwertigen Flexodruckformen mittels thermischer Entwicklung produzieren.

Methoden zur Herstellung von Styrol-Butadien-Blockcopolymeren sind dem Fachmann bekannt, ebenso Techniken, welche den Einbau von Butadien in das Polymer gezielt in Richtung 1,2-Verknüpfung oder 1,4-Verknüpfung zu steuern. Dies kann beispielsweise über die Wahl des Lösemittels erfolgen. In polaren Lösemitteln erfolgt der Einbau bevorzugt in 1,2-Stellung und in unpolaren Lösemitteln bevorzugt in 1,4-Stellung. Styrol-Butadien-Blockcopolymere mit hohem Vinylgehalt sind kommerziell erhältlich, beispielsweise unter dem Namen Kraton®.

Selbstverständlich kann auch ein Gemisch mehrerer Styrol-Butadien-Blockcopolymerer eingesetzt werden. Die Menge des oder der Styrol-Butadien-Blockcopolymere mit hohem Vinylgehalt beträgt 35 bis 50 Gew. % und bevorzugt 37 bis 49 Gew. %.

Neben dem oder den vinylgruppenreichen Styrol-Butadien-Blockcopolymeren kann die reliefbildende Schicht optional noch eines oder mehrere sekundäre, Bindemittel aufweisen. Derartige sekundäre Bindemittel können vom Fachmann zur Feinsteuerung der Eigenschaften der späteren Druckform eingesetzt werden. Beispielsweise lassen sich die Elastizität oder die Farbannahme der Druckform beeinflussen. Weiterhin kann auch eine eventuell auftretende, zu hohe Anisotropie durch ein sekundäres Bindemittel kompensiert werden.

Die Auswahl sekundärer Bindemittel ist prinzipiell nicht beschränkt, solange die Eigenschaften der reliefbildenden Schicht dadurch nicht beeinträchtigt werden. Beispiele geeigneter sekundärer Bindemittel umfassen Ethylen-Propylen-Dien-Terpolymere, Ethylen-Octen-Copolymere, Ethylen-Vinylacetat-Copolymere, Nitrilkautschuk, Naturkautschuk, Butylkautschuk, Polyisobutylen, Polyisopren, Polybutadien, Polychloropren, Styrol-Dien-Blockcopolymere, hydrierte Styrol-Dien-Blockcopolymere, Polyvinylbutyral oder Styrol-Butadien-Emulsionscopolymere.

Zur Ausführung des erfindungsgemäßen Verfahrens als sekundäre Bindemittel geeignet sind insbesondere Styrol-Butadien-Blockcopolymere, welche im Hinblick auf Molekulargewicht und/oder Styrol-Gehalt und/oder Vinylanteil außerhalb der oben aufgeführten Definition liegen. Insbesondere kann es sich um Styrol-Butadien-Blockcopolymere handeln, welche einen Anteil von weniger als 15 Gew. % an 1,2-verknüpften Butadieneinheiten aufweisen. Besonders bevorzugt als sekundäre Bindemittel sind Zweiblock-Copolymere, beispielsweise solche mit einem Molekulargewicht $M_w$ von 150 000 bis 300 000 g/mol und einem Styrolgehalt von 5 bis 15 Gew. %. Mit derartigen Blockcopolymeren lässt sich Anisotropie besonders wirkungsvoll kompensieren.

Die Menge eines sekundären Bindemittels wird vom Fachmann je nach den gewünschten Eigenschaften der Druckplatte bestimmt. Sie sollte aber im Regelfalle 20 Gew. %, bevorzugt 15 Gew. % bezüglich der Summe aller Bestandteile der Schicht nicht überschreiten. In jedem Falle ist die eingesetzte Menge geringer als die der primären Bindemittel vom Typ der vinylreichen Styrol-Butadien-Blockcopolymere.

Die Menge aller primären und sekundären Bindemittel in der reliefbildenden Schicht zusammen sollte 65 Gew. % nicht überschreiten. Sie liegt im Regelfalle bei 35 bis 65 Gew. %. Bei größeren Mengen wird in aller Regel keine gute thermische Entwickelbarkeit mehr erreicht, und außerdem wird die Anisotropie der erhaltenen Flexodruckelemente zu groß. Bei geringeren Mengen werden keine guten Reliefschichten mehr erhalten. Bevorzugt beträgt die Menge 35 bis 60 Gew. % und besonders bevorzugt bei 40 bis 55 Gew. %.

Die reliefbildende Schicht umfasst weiterhin mindestens einen Weichmacher. Durch die Kombination des erfindungsgemäß eingesetzten Bindemittels mit dem Weichmacher wird die gute thermische Entwickelbarkeit erreicht.

Die Menge des eingesetzten Weichmachers beträgt 25 bis 50 Gew. %. Bei geringeren Mengen wird in aller Regel keine gute thermische Entwickelbarkeit erreicht, und bei höheren Weichmachermengen werden keine Reliefschichten mit guten Druckeigenschaften mehr erhalten. Bevorzugt beträgt die Menge 30 bis 50 Gew. %, und besonders bevorzugt 35 bis 45 Gew. %.

Die optimale Weichmachermenge kann dabei auch vom Schmelzflussindex des jeweils eingesetzten Bindemittels beeinflusst werden. Hat das Bindemittel einen vergleichsweise hohen Schmelzflussindex, so kann sich die Weichmachermenge im Regelfalle eher an der unteren Grenze orientieren. Weist das Bindemittel einen vergleichsweise niedrigen Schmelzflussindex auf, so ist im Regelfalle eine eher höhere Weichmachermenge empfehlenswert. Bei einem SBS-Blockcopolymer mit jeweils 30 Gew. % Styrol empfiehlt sich bei einem Schmelzflussindex von 0,5 bis 1 (gemessen bei 200°C / 5kg nach DIN EN ISO 1133) eine Weichmachermenge von 35 bis 40 Gew. %, bei einem Schmelzflussindex von ca. 6 sind im Regelfalle 25 bis 30 Gew. % ausreichend.

Beispiele für geeignete Weichmacher umfassen insbesondere modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere $\alpha$-Methylstyrol-/-Methylstyrol-Copolymere, flüssige Oligobutadiene, insbesondere solche mit einem Molekulargewicht zwischen 500 und 5000 g/mol, flüssige Oligoisoprene oder flüssige oligomere Acrylnitril-Butadien-Copolymere oder oligomere Ethylen-Propylen-Dien-Copolymere.

Bevorzugt sind vinylgruppenreiche Polybutadienöle, insbesondere solche, bei denendie Butadieneinheiten zu mindestens 40 Gew. % 1,2-verknüpft eingebaut sind. Weiterhin bevorzugt sind hochsiedende aliphatische Ester und Mineralöle sowie hochsiedende, im wesentlichen paraffinische und / oder naphthenische Mineralöle. Zum Beispiel sind sogenannte paraffinbasische Solvate und Spezialöle unter den Namen Shell Catenex S und Shell Catenex PH kommerziell erhältlich. Der Fachmann unterscheidet bei Mineralölen technische Weißöle, die noch einen sehr geringen Aromatengehalt aufweisen können, sowie medizinische Weißöle, die im wesentlichen aromatenfrei sind. Sie sind kommerziell erhältlich, beispielsweise unter den Namen Shell Risella (technisches Weißöl) oder Shell Ondina (medizinisches Weißöl).

Bevorzugt wird zur Ausführung des erfindungsgemäßen Verfahrens ein Gemisch von mindestens zwei verschiedenen Weichmachern eingesetzt, welches mindestens ein Polybutadienöl umfasst. Besonders bevorzugt umfasst das Gemisch weiterhin mindestens ein Mineralöl, insbesondere im wesentlichen paraffinische und / oder naphthenische Mineralöle.

Selbstverständlich kann auch ein Gemisch zweier verschiedener Mineralöle sowie zweier verschiedener Polybutadienöle eingesetzt werden. Bevorzugt beträgt das Gewichtsverhältnis der beiden Gruppen von Weichmachern 3:1 bis 1:3, bevorzugt 2:1 bis 1:2.

Zur Ausführung des erfindungsgemäßen Verfahrens hat es sich regelmäßig bewährt darauf zu achten, dass der Gesamtvinylgehalt in der reliefbildenden Schicht, also der Gewichtsanteil von 1,2-gebundenem Butadien in den Bindemitteln und Weichmachern zusammen, mindestens 20 Gew. % bezüglich aller Komponenten der reliefbildenden Schicht beträgt.

Die fotopolymerisierbare reliefbildende Schicht umfasst weiterhin in bekannter Art und Weise polymerisierbare Verbindungen, beziehungsweise Monomere. Die Monomeren sollen mit dem Olefin / (Meth)acrylat-Copolymeren verträglich sein und mindestens eine polymerisierbare, ethylenisch ungesättigte Doppelbindung aufweisen. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure oder Allylverbindungen erwiesen. Beispiele für geeignete Monomere sind Butylacrylat, 2-Ethylhexylacrylat, Laurylacrylat, 1,4-Butandioldiacrylat, 1,6-Hexandioldiacrylat, 1,6-Hexandioldimethacrylat, 1,9-Nonandioldiacrylat, Trimethylolpropantri(meth)acrylat, Dioctylfumarat, N-Dodecylmaleimid. Die Menge an Monomeren in der reliefbildenden Schicht beträgt in der Regel 4,9 bis 30 Gew. % bzgl. der Menge aller Bestandteile, bevorzugt 4,9 bis 20 Gew. %.

Die fotopolymerisierbare reliefbildende Schicht weist weiterhin in prinzipiell bekannter Art und Weise einen Fotoinitiator oder ein Fotoinitiatorsystem auf. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew. % bzgl. der Menge aller Bestandteile der reliefbildenden Schicht.

Die reliefbildende Schicht kann optional weitere Bestandteile wie beispielsweise Inhibitoren für die thermisch initiierte Polymerisation, Farbstoffe, Pigmente, fotochrome Zusätze oder Antioxidantien umfassen. Im Regelfalle sollten aber nicht mehr als 10 Gew. % bezüglich der Summer aller Bestandteile der Schicht, bevorzugt nicht mehr als 5 Gew. % eingesetzt werden.

Bei der fotopolymerisierbaren reliefbildenden Schicht kann es sich auch um mehrere fotopolymerisierbare Schichten übereinander handeln, die eine gleiche, annährend gleiche oder verschiedene Zusammensetzung aufweisen. Ein mehrschichtiger Aufbau hat den Vorteil, dass die Eigenschaften der Oberfläche der Druckform, wie beispielsweise Farbübertragung verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

Es ist häufig zum Drucken vorteilhaft, dass die Oberfläche der Reliefschicht härter ist, als die darunter liegende Reliefschicht. Dies kann vorteilhaft erreicht werden, in dem der Fachmann sich bei der Zusammensetzung der Oberschicht bezüglich des Gehaltes an Weichmacher eher an der Untergrenze der offenbarten Bereiche und beim Bindemittelgehalt eher an der Obergenze orientiert und bei der Zusammensetzung der Unterschicht umgekehrt vorgeht. Beispielsweise kann die Oberschicht 25 bis 30 Gew. % Weichmacher enthalten und die Unterschicht 40 bis 50 Gew. %. Typischerweise weist eine derartige harte Oberschicht falls vorhanden- eine Dicke von nicht mehr als 0,1 mm, bevorzugt 0,01 - 0,1 mm auf, ohne dass die Erfindung darauf beschränkt sein soll.

Die Oberschicht kann aber auch eine von der erfindungsgemäßen Zusammensetzung abweichende Zusammensetzung aufweisen, solange im Zuge der thermischen Entwicklung keine negativen Effekte beobachtet werden.

Das Flexodruckelement kann neben der reliefbildenden Schicht optional noch weitere Schichten umfassen.

Beispiele derartiger Schichten umfassen eine elastomere Unterschicht aus einer anderen Formulierung, die sich zwischen dem Träger und der bzw. den reliefbildenden Schicht(en) befindet. Mit derartigen Unterschichten können die mechanischen Eigenschaften der Flexodruckplatten verändert werden, ohne die Eigenschaften der eigentlichen druckenden Reliefschicht zu beeinflussen.

Dem gleichen Zweck dienen sogenannte elastische Unterbauten, die sich unter dem dimensionsstabilen Träger des Flexodruckelementes befinden, also auf der von der reliefbildenden Schicht abgewandten Seite des Trägers.

Weitere Beispiele umfassen Haftschichten, die den Träger mit darüber liegenden Schichten oder verschiedene Schichten untereinander verbinden.

Die Dicke der reliefbildenden Schicht(en) wird vom Fachmann je nach dem gewünschten Verwendungszweck der Flexodruckform bestimmt und beträgt im Regelfalle 0,5 bis 7 mm, bevorzugt 0,5 bis 5 mm und besonders bevorzugt 0,6 bis 2,5 mm.

Das fotopolymerisierbare Flexodruckelement kann weiterhin eine lichtdurchlässige, nicht klebrige Deckschicht aufweisen. Derartige Deckschichten sind auch als Substratschichten oder als release-layer bekannt. Sie erleichterten das Abziehen einer eventuell vorhandenen Schutzfolie vor dem Gebrauch des Flexodruckelementes und vermeiden so eine Beschädigung der reliefbildenden Schicht. Sie erleichtern weiterhin das Auflegen und Abnehmen des fotografischen Negativs zur Bebilderung. Substratschichten werden von einem reissfeste Filme bildenden Polymeren und den gegebenenfalls darin enthaltenen Zusatzstoffen gebildet. Beispiele geeigneter, reissfeste Filme bildender Polymerer sind Polyamide, voll- oder teilverseifte Polyvinylacetate oder Polyethylenoxid/Vinylacetat-Pfropfpolymerisate. Im allgemeinen sind die Substratschichten 0,2 bis 25 μm dick, bevorzugt beträgt die Dicke 2 bis 20 μm.

Das als Ausgangsmaterial eingesetzte Flexodruckelement kann optional noch durch eine Schutzfolie, beispielsweise eine Schutzfolie aus PET, vor Beschädigungen geschützt werden, die sich auf der jeweils obersten Schicht des Flexodruckelements, also im Regelfalle auf der Substratschicht, befindet. Falls das fotoempfindliche Flexodruckelement eine Schutzfolie aufweist, muss diese vor der Durchführung des erfindungsgemäßen Verfahrens abgezogen werden.

Die Herstellung des erfindungsgemäßen Flexodruckelementes bietet keinerlei Besonderheiten und kann nach den dem Fachmann prinzipiell bekannten Methoden beispielsweise durch Kneten der Bestandteile und Ausformen der Schicht durch Pressen, mittels Extrusion und Kalandrieren zwischen Trägerfolie und Deckfolie oder durch Aufgießen der gelösten Bestandteile der Schicht auf die - im Regelfalle substratbeschichtete- Schutzfolie oder den dimenssionsstabilen Träger erfolgen. Bevorzugt erfolgt die Herstellung mittels Extrusion und Kalandrieren zwischen Trägerfolie und Deckfolie.

In einer bevorzugten Ausführungsform werden zunächst das Styrol-Butadien-Blockcopolymere oder auch alle Bindemittel mit einem Teil des Weichmachers in einem geeigneten Mischaggregat zu einer homogenen Masse zu verarbeiten. Die erhaltene Masse wird danach in einem zweiten Schritt im Extruder zusammen mit den anderen Bestandteile der Schicht und dem Rest des Weichmachers weiterverarbeitet. Vorteilhaft kann dadurch auch eine größere Menge Weichmacher auf kurzer Extruderlänge eingearbeitet und außerdem eine besonders homogene Einarbeitung des Weichmachers erreicht werden. Außerdem können die Verweilzeiten der polymeren Masse in der heißen Zone des Extruders vermindert werden. Diese Vorgehensweise hat sich insbesondere bei Verwendung von Weichmachern auf Basis von Mineralölen bewährt. Falls das bevorzugte Gemisch aus Mineralölen und Polybutadienölen eingesetzt wird, wird bevorzugt das Mineralöl vorher in das Blockcopolymer eingearbeitet, während das Polybutadienöl erst später zugegeben wird. Die beschriebene Vorgehensweise mit Pre-Compoundierung hat auch den Vorteil, dass die Herstellung bei niedrigeren Extruderauslastungen und geringerer thermischer Belastung im Extruder erfolgen kann.

Das soeben offenbarte Flexodruckelement ist zur konventionellen Bebilderung mittels fotografischer Masken vorgesehen. In einer weiteren Ausführungsform der Erfindung kann es sich auch um ein digital bebilderbares Flexodruckelement handeln. Hierbei weist das Flexodruckelement eine zusätzliche digital bebilderbare Schicht auf. Diese kann sich auf der transparenten Substratschicht befinden, es kann beim Vorhandensein digital bebilderbarer Schichten aber auch auf die Substratschicht verzichtet werden.

Bei der digital bebilderbaren Schicht handelt es sich bevorzugt um eine Schicht ausgewählt aus der Gruppe der IR-ablativen Schichten, Ink-Jet-Schichten oder thermografischen Schichten.

IR-ablative Schichten bzw. Masken sind für die Wellenlänge des aktinischen Lichtes opak und umfassen üblicherweise ein filmbildendes thermisch zersetzbares Bindemittel sowie mindestens einen IR-Absorber wie beispielsweise Ruß. Ruß sorgt auch dafür, dass die Schicht opak ist. Als Bindemittel kommen sowohl organisch lösliche Bindemittel wie beispielsweise Polyamide oder Nitrocellulose wie auch wässrig lösliche Bindemittel beispielsweise Polyvinylalkohol oder Polyvinylalkohol / Polyethylenglykol-Propfcopolymere in Betracht. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt werden. Beispiele für die Bebilderung von Flexodruckelementen mit IR-ablativen Masken sind beispielweise in EP-A 654 150 oder EP-A 1 069 475 offenbart.

Bei Ink-Jet-Schichten wird eine transparente, mit Ink-Jet-Tinten beschreibbare Schicht, beispielsweise eine Gelatine-Schicht aufgetragen. Diese ist mittels Ink-Jet-Druckem mit opaken Tinten bedruckbar. Beispiele sind in EP-A 1 072 953 offenbart.

Bei thermografischen Schichten handelt es sich um transparente Schichten, die Substanzen enthalten, die sich unter dem Einfluss von Hitze schwarz färben. Derartige Schichten umfassen beispielsweise ein Bindemittel und ein anorganisches oder organisches Silbersalz und können mittels eines Druckers mit Thermokopf bebildert werden. Beispiele sind in EP-A 1 070 989 offenbart.

Bei der digital bebilderbaren Schicht kann es sich auch um eine sogenannte peel-off-Schicht handeln, wie beispielsweise von EP-A 654 151 offenbart.

In einer bevorzugten Ausführungsform sind die digital bebilderbaren Schichten in Wasser oder überwiegend wässrigen Lösemittelmischungen löslich.

Die digital bebilderbaren Schichten können auf die fotopolymerisierbare Schicht oder die Substratschicht in prinzipiell bekannter Art und Weise aufgegossen werden.

Zur Durchführung des erfindungsgemäßen Verfahren wird das Flexodruckelement als Ausgangsmaterial eingesetzt. Falls das Flexodruckelement eine Schutzfolie umfasst, wird diese zunächst abgezogen. In den ersten Verfahrensschritten wird das Flexodruckelement bildmäßig bebildert und anschließend in weiteren Verfahrensschritten thermisch entwickelt.

In Verfahrensschritt (a) wird die fotopolymerisierbare reliefbildende Schicht zunächst bildmäßig mittels aktinischer Strahlung belichtet. Die bildmäßige Belichtung kann mittels der prinzipiell bekannten Verfahren erfolgen.

Beim konventionellen Verfahren wird zur Bebilderung der reliefbildenden Schicht im Verfahrensschritt (a) eine fotografische Maske aufgelegt. Anschließend wird das Flexodruckelement durch die aufgelegte Maske hindurch mit aktinischem Licht belichtet.

Als aktinisches, also chemisch "wirksames" Licht eignet sich in bekannter Art und Weise insbesondere UVA- bzw. UV/VIS-Strahlung. Durch die Bestrahlung wird die fotopolymerisierbare Schicht in den nicht abgedeckten Bereichen vernetzt. Um eine störungsfreie Auflage des fotografischen Negativs zu erhalten, kann die Belichtung in bekannter Art und Weise unter Verwendung einer Vakuumfolie, eines Vakuumrahmens oder unter einer Glasplatte vorgenommen werden.

Falls der dimensionsstabile Träger transparent ist, kann das Flexodruckelement optional in einem (a) vorgelagerten Verfahrensschritt von der Rückseite her mit aktinischem Licht bestrahlt werden. Durch einen solchen Schritt kann die Relieftiefe festgelegt werden und er trägt zu einer besseren Verankerung der Reliefelemente bei.

In den Verfahrensschritten (b) und (c) des erfindungsgemäßen Verfahrens wird das bildmäßig belichtete Flexodruckelement thermisch entwickelt. Die beiden Verfahrensschritte können nacheinander oder auch gleichzeitig durchgeführt werden.

Im Verfahrensschritt (b) wird das Flexodruckelement erwärmt, so dass die nicht polymerisierten Anteile der reliefbildenden Schicht erweichen, sich verflüssigen oder schmelzen. Dem Fachmann ist bewusst, dass der Begriff "schmelzen" im Hinblick auf die Masse aus Polymer, Weichmacher, Monomer, Fotoinitiator sowie gegebenenfalls anderen Zusätzen nicht so präzise wie bei reinen, niedermolekularen Stoffen definierbar ist. Gemeint ist hier, dass die Viskosität der Masse so weit erniedrigt werden soll, dass sie in Verfahrensschritt (c) von einem Vlies absorbiert oder anderweitig entfernt werden kann.

Das Flexodruckelement wird in Schritt (b) zumindest für eine oder mehrere kurze Zeitphasen auf eine Temperatur erwärmt, die hoch genug ist, um die nicht polymerisierten Schichtanteile in ausreichendem Maße zu verflüssigen, jedoch ohne die polymerisierten Anteile der Schicht zu beschädigen. Im allgemeinen ist dazu eine Temperatur 40 bis 200°C erforderlich. Bevorzugt wird das Flexodruckelement auf eine Temperatur von 80 bis 170°C erwärmt.

Das Erwärmen kann beispielsweise durch Bestrahlen mit einer Hitzequelle, beispielsweise mittels eines IR-Strahlers, erfolgen. Weitere Beispiele umfassen das Eintauchen in Wärmebäder, das Erhitzen mittels heißer Luft- oder Flüssigkeitsströme oder Kontaktieren des Flexodruckelementes mit heißen Flächen ohne dass die Erfindung darauf beschränkt sein soll. Es kann auch eine Kombination mehrerer Methoden verwendet werden. Bevorzugt wird das Flexodruckelement von der Vorderseite her erwärmt. Hierbei weist die Oberfläche der reliefbildenden Schicht üblicherweise eine höhere Temperatur auf, als die unterhalb der Oberfläche gelegenen Bereiche der Schicht.

In Schritt (c) werden die erweichten, nicht polymerisierten Anteile der reliefbildenden Schicht entfernt. Die polymerisierten Anteile bleiben auf dem Träger zurück wodurch sich das Druckrelief ausbildet.

Schritt (c) kann beispielsweise so vorgenommen werden, indem man die erwärmte reliefbildende Schicht mit einem absorbierenden Material kontaktiert. Die erwärmten, verflüssigten, nicht polymerisierten Anteile der reliefbildenden Schicht werden hierbei vom absorbierenden Material absorbiert. Um eine möglicht effiziente Absorption zu erreichen, sollte ein möglichst inniger Kontakt zwischen dem absorbierenden Material und der Oberfläche des Flexodruckelementes hergestellt werden. Beispielsweise kann das absorbierende Material auf die Oberfläche gelegt und anschließend angedrückt werden. Nach dem Vollsaugen des absorbierenden Materials mit der polymeren Masse wird das absorbierende Material von der noch warmen Flexodruckplatte wieder abgezogen. Um eine möglichst vollständige Entfernung des erweichten Materials zu gewährleisten ist es regelmäßig empfehlenswert, diesen Vorgang mit frischem absorbierenden Material so oft zu wiederholen, bis alles verflüssigte Material entfernt ist. Als absorbierende Materialien eignen sich geeignete poröse Materialien, beispielsweise Vliese aus Nylon, Polyester oder Cellulose. Weitere Details zur Durchführung von Schritt (c) sind in WO 01/88615, Seite 15, Zeile 6 bis Seite 17, Zeile 2 offenbart, auf die wir an dieser Stelle ausdrücklich verweisen.

Die Schritte (b) und (c) können nacheinander vorgenommen werden, werden aber im Regelfalle im wesentlichen gleichzeitig vorgenommen. Die Schicht kann schon während des Aufheizens mit dem Vlies bedeckt werden und im Regelfalle ist es notwendig, auch während des Schrittes (c) Wärme zuzuführen, um unerwünschtes Abkühlen des Flexodruckelementes und somit unvollständiger Entfernung des polymeren Materials zu vermeiden.

In einer alternativen Ausführungsform für Verfahrensschritt (c) erfolgt die Entfernung durch Bearbeitung des erwärmten Flexodruckelementes mit einem heißen Luft- oder Flüssigkeitsstrom unter Druck. Beispielsweise kann das Flexodruckelement mit Wasserdampf unter Druck von der Oberseite her abgestrahlt werden. Der heiße Wasserdampfstrom sorgt einerseits für die Erwärmung des Flexodruckelementes und die Erweichung der nicht polymerisierten Anteile der reliefbildenden Schicht. Die mechanische Energie des Strahles sorgt für die Trennung der verflüssigten Masse von den polymerisierten Anteilen. Weitere Details sind in WO 01/90818 Seite 3, Zeile 5 bis 16 offenbart.

Die durch thermische Entwicklung erhaltene Druckform kann optional auch noch nachbehandelt werden. Sie kann beispielsweise vollflächig mittels aktinischem Licht nachbelichtet werden. Sie kann weiterhin auf prinzipiell bekannte Art und Weise mittels $Br_2$-Lösung oder mittels Bestrahlung durch UV-C-Licht oberflächlich entklebt werden.

Das erfindungsgemäße Verfahren ist bei Verwendung von Flexodruckelementen mit digital bebilderbaren Schichten ist dem oben beschriebenen sehr ähnlich. Anstelle der Verwendung einer fotografischen Maske wird in einem Verfahrensschritt (a) vorgelagerten Schritt die digital bebilderbare Schicht mittels der jeweils notwendigen Technik bebildert und somit quasi in situ auf der reliefbildende Schicht eine Maske erzeugt.

Bei Verwendung IR-ablativer Masken wird die IR-ablative Schicht mit Hilfe eines IR-Lasers teilweise -entsprechend dem gewünschten Bild- entfernt. Es werden dabei diejenigen Bereiche freigelegt, die später vernetzt werden sollen und die Reliefelemente bilden. Bei Verwendung von Ink-Jet-Schichten oder thermografischen Schichten wird die digital bebilderbare Schicht mittels Ink-Jet-Druckern bzw. thermografischen Druckern in denjenigen Bereichen bedruckt, die im Zuge der Bestrahlung nicht vernetzt werden sollen.

Nach dem Erzeugen einer Maske aus der digital bebilderbaren Schicht wird wie bei Verwendung einer fotografischen Maske mittels aktinischem Licht bestrahlt. Ein Vakuumrahmen zur Belichtung ist nicht erforderlich. Vorzugsweise wird mittels eines Flachbettbelichters an Luft belichtet.

Die belichteten Flexodruckelemente können als solche, d.h. inklusive der digital bebilderbaren Schicht oder den Resten davon zur thermischen Entwicklung eingesetzt werden.

In einer bevorzugten Ausführungsform wird die digital bebilderbare Schicht in einem Verfahrensschritt (b) vorgelagerten Verfahrensschritt entfernt. Das vorherige Ablösen der digital bebilderbaren Schicht spart Zeit bei der thermischen Entwicklung und verhindert eine Kontamination des thermischen Verarbeitungsgerätes mit Bestandteilen der Maskenschicht. Die Entfernung der digital bebilderbaren Schicht kann beispielsweise durch Abziehen oder durch Ablösen mittels eines geeigneten Lösemittels geschehen. In einer besonders bevorzugten Ausführungsform wird eine wasserlösliche oder zumindest in Wasser quellbare digital bebilderbare Schicht eingesetzt. Die digital bebilderbare Schicht bzw. die Reste davon können nach der Bebilderung und Bestrahlung mit aktinischem Licht mit Wasser oder überwiegend wässrigen Lösemitteln abgelöst werden. Das Ablösen kann optional durch sanfte mechanische Behandlung, beispielsweise durch Bürsten unterstützt werden. Da die erfindungsgemäß eingesetzten Styrol-Butadien-Blockcopolymere nur in organischen Lösemitteln bzw. Lösemittelgemischen löslich sind, werden die nicht polymerisierten Anteile der reliefbildenden Schicht weder gelöst noch die polymerisierten Anteile aufgequollen. Das so vorbehandelte Flexodruckelement kann daher direkt im Anschluss weiter verarbeitet werden, ohne dass eine vorherige Trocknung notwendig wäre.

Die erfindungsgemäß eingesetzten Flexodruckelemente zeichnen sich dadurch aus, dass sie nicht nur thermisch entwickelt, sondern auch auf konventionelle Art und Weise mittels Auswaschmitteln entwickelt werden können. Bei der konventionellen Entwicklung wird im Anschluss an das bildmäßige Belichten des Flexodruckelementes das belichtete Flexodruckelement in bekannter Art und Weise mit einem organischen Lösemittel oder Lösemittelgemisch entwickelt. Diese mehrfache Nutzungsmöglichkeit ist sowohl beim Produzenten wie beim Verwender ökonomisch vorteilhaft.

Die erfindungsgemäß eingesetzten Flexodruckelemente können weiterhin auch als Ausgangsmaterial zur Herstellung von Flexodruckformen mittels Laser-Direktgravur eingesetzt werden. Hierzu wird ein Flexodruckelement eingesetzt, welches keine digital bebilderbare Schicht aufweist. Dieses wird in einem ersten Verfahrensschritt vollflächig, d.h. ohne Auflegen einer Maske, mittels aktinischem Licht vernetzt. In die vollflächig vernetzte reliefbildende Schicht kann anschließend mittels eines $CO_2$-Laser direkt das Druckrelief eingraviert werden. Die vernetzte Schicht wird an den Stellen, an denen Sie vom Laser getroffen wird, thermisch zersetzt. Nähere Einzelheiten zur Technik der Laser-Direktgravur zur Herstellung von Flexodruckformen sind beispielsweise in EP-A 1 136 254 und US 5,259,311 offenbart.

Mittels des erfindungsgemäßen Verfahrens werden Flexodruckformen mittels thermischer Entwicklung in bislang unbekannter Qualität erhalten. Feine positive Elemente, wie Raster, Linien und feine Schriften werden sauber abgebildet. Der Belichtungsspielraum ist positiv. Die für das Verfahren eingesetzten Flexodruckelemente können besonders ökonomisch mittels Extrusion bei relativ niedrigen Temperaturen hergestellt werden. Sie eignen sich weiterhin auch für andere Anwendungen.

Die folgenden Beispiele sollen die Erfindung näher illustrieren:

Herstellung der eingesetzten Flexodruckelemente, Allgemeine Vorschrift

Die Herstellung der zum erfindungsgemäßen Verfahren eingesetzten Flexodruckelemente erfolgt nach dem üblichen Verfahren. In den nachfolgenden Beispielen wurde die fotopolymerisierbare Masse extrudiert, durch eine Breitschlitzdüse ausgetragen und zwischen einer Trägerschicht und einem Deckelement kalandriert. Dieses Verfahren ist in EP-B 084 851 detailliert beschrieben.

In den unten aufgeführten Beispielen bestand das Deckelement aus einer PET-Deckfolie, die mit einer ca. 3 μm dicken Substratschicht aus ca. 80 Gew. % Polyamid (Macromelt® 6900, Fa. Henkel) und ca. 20 Gew. % eines Styrol-Acrylat-Copolymers (Joncryl® 586, Fa. Johnson Polymer Inc.) beschichtet war. Die Substratschicht verbleibt nach dem Abziehen der Deckfolie auf der fotopolymerisierbaren Masse. Sie verhindert bei der Verarbeitung des Anhaften des Negativfilms und schützt den Verarbeiter vor dem direkten Kontakt mit Monomeren und anderen reaktiven Inhaltsstoffen.

Als Extrusionsanlage wurde ein Zweischneckenextruder (ZSK 53, Werner & Pfleiderer) bei einem Durchsatz von 30 kg/h verwendet. Die Kalandrierung erfolgte zwischen zwei auf 90 °C beheizten Kalanderwalzen, wobei die über die obere Kalanderwalze die Trägerfolie und über die untere Kalanderwalze das Deckelement geführt wurde.

Der erhaltene Sandwichverbund wurde über ein Saugband transportiert, abgekühlt und konfektioniert.

Details zur Zusammensetzung der fotopolymisierbaren Masse, Herstellparametern und den verwendeten Träger- und Deckelementen sind in den jeweiligen Beispielen beschrieben.

Bildmäßige Belichtung der Flexodruckelemente

Vor der bildmäßigen Belichtung wurde eine vollflächige Rückseitenbelichtung für die in den Beispielen genannte Zeitspanne durchgeführt.

Die bildmäßige Belichtung der Flexodruckelemente erfolgte dem nach allgemein üblichen Verfahren durch ein Negativ mittels UV-Licht für die jeweils angegebene Zeitdauer, wobei die Deckfolie der fotopolymerisierbaren Druckplatte vor der bildmäßigen Belichtung entfernt wurde. Die bildmäßige Belichtung erfolgte nach Auflegen des Negativfilms durch eine Vakuumfolie, die bei einem Druck von ca. 200 mbar den Negativfilm gleichmäßig auf der Oberfläche des Flexodruckelements fixiert und den Sauerstoffgehalt während der Belichtung reduziert.,

Als Belichtungsgerät für die bildmäßige Belichtung und die vollflächige Rückseitenvorbelichtung wurde ein nyloflex® F III-Belichter (BASF Drucksysteme GmbH, Stuttgart) verwendet.

Entwicklung der Flexodruckelemente

a) Entwicklung der Flexodruckelemente mittels Entwicklerlösungen

Die Entwicklung der bildmäßig belichteten Flexodruckelemente mittels Auswaschmittel wurde unter Verwendung eines handelsüblichen Auswaschmittels für Flexodruckplatten vorgenommen (nylosolv® II, BASF Drucksysteme GmbH) in einem ebenfalls handelsüblichen Auswaschgerät (nyloflex® Durchlaufwascher F III, BASF Drucksysteme GmbH) vorgenommen.

Im Anschluss an den Entwicklungsprozess mittels Entwicklerlösungen wurden die noch gequollenen Flexodruckelemente in einem Umlufttrockner bei 60°C so lange getrocknet, bis die Soll-Schichtdicke für den Druckprozess erreicht ist. Dieser Prozess dauerte je nach Zusammensetzung der Druckplatte 2 - 3 Stunden.

b) Thermische Entwicklung der Flexodruckelemente

Die thermische Entwicklung der bildmäßig belichteten Flexodruckelemente erfolgte in Anlehnung an das WO 01/88615 offenbarte Verfahren mit Hilfe eines kommerziell erhältlichen Verarbeitungsgerätes vomTyp "FAST 1000 TDe Prozessor" (DuPont Cyrel®). Hierbei wird die bildmäßig belichtete Druckplatte auf eine auf 23°C temperierte Trommel gespannt. Im Laufe einer vollständigen Trommelumdrehung wird die Druckplatte zunächst mit Hilfe von Infrarot-Strahlern von der Oberfläche her erwärmt. Ein Vlies wird über einer beheizten Walze im Mitlauf gegen die erwärmte Flexodruckplatte gepresst und nimmt die erwärmten, unpolymerisierten Bestandteile der Flexodruckplatte auf. Eine Trommelumdrehung wird als 1 Zyklus definiert. Die Temperatur der beheizten, Vlies-führenden Walze betrug 163 °C. Im Laufe mehrerer Zyklen werden die Intensität der IR-Bestrahlung und der Anpressdruck des Vlieses gegen die Flexodruckplatte schrittweise um insgesamt ca. 40 % reduziert. Die Platte wird nach der in den Beispielen genannten Anzahl von Verarbeitungszyklen entnommen.

Nachbehandlung der entwickelten Flexodruckelemente

Die nachfolgend beschriebenen Flexodruckelemente wurden im Anschluss an den Entwicklungsprozess zunächst mit Hilfe eines nyloflex® F III-Belichters (BASF Drucksysteme GmbH, Stuttgart) 10 Minuten vollflächig mit UVA-Licht bestrahlt. Die Nachbelichtung dient dazu, verbliebene reaktive Komponenten der Druckplatte chemisch umzusetzen.

Anschließend wurde die Oberfläche der Druckplatte in einem UVC-Bestrahlungsgerät für 10 Minuten nachbehandelt. Hierdurch wird eine klebfreie Druckoberfläche erhalten.

Bestimmung des Belichtungsspielraumes

Die zur bildmäßigen Belichtung verwendeten Testnegative enthalten sogenannte Positivelemente (erhabene Bildelemente) und Negativelemente (nichtdruckende Elemente umgeben von vollflächigen Bereichen). Nach der vollständigen Verarbeitung der Druckplatte müssen die Bildelemente bestimmte Grenzkriterien erfüllen, um als korrekt ausgebildet bewertet zu werden. In der nachfolgenden Tabelle sind die zur Ermittlung des Belichtungsspielraums verwendeten Bildelemente zusammen mit den Elementdimensionen und Grenzkriterien aufgeführt.

| Bildelement | Elementdimensionen | Grenzkriterium |
|---|---|---|
| Positivelemente | | |
| Positivpunkt | 200 μm (Durchmesser) | fehlerfrei ausgebildet, Oberfläche homogen |
| Gitternetz | 55 μm (Linienbreite) | fehlerfrei ausgebildet, ohne Wellen |
| Positivlinie | 100 μm (Linienbreite) | fehlerfrei ausgebildet, ohne Wellen |
| 2 % Raster | 2 % Raster bei 60 Ucm | vollständig ausgebildet, keine Ausbrüche |
| Negativelemente | | |
| Negativpunkt | 400 μm (Durchmesser) | Tiefe mindestens 70 μm |
| Negativlinie | 2 mm (Linienbreite) | Tiefe mindestens 500 μm |

Die bildmäßige Belichtung erfolgt mittels 8 Testnegativen. Beginnend bei 4 min Belichtungszeit wird die Druckplatte durch die Testnegative mit jeweils 2 Minuten zunehmender Belichtungszeit belichtet, d.h. in Schritten von ingesamt 4, 6, 8, 10, 12, 14, 16 und 18 Minuten. Für jedes Bildelement wird diejenige Belichtungszeit ermittelt, bei der die Ausbildung erstmalig korrekt ist (Positivelemente) bzw. gerade noch das Grenzkriterium erfüllt ist (Negativelemente).

Die untere Belichtungsgrenze (UBG oder LEL = lower exposure limit) ist das Maximum der Belichtungszeiten aller Positivelemente, die obere Belichtungsgrenze (OBG oder UEL = upper exposure limit) ist das Minimum der Belichtungszeiten aller Negativelemente. Der Belichtungsspielraum (BSPR oder exposure latitude) ist die Differenz OBG - UBG (UEL - LEL). Wünschenswert ist ein möglichst großer, positiver Belichtungsspielraum.

Bestimmung des Anisotropiefaktors

Ein Flexodruckelement sollte sich isotrop verhalten, d.h. die mechanischen und Druckeigenschaften sollten unabhängig von der Orientierung des Flexodruckelements in der Druckmaschine sein. Ein Maß für den Anisotropiegrad ist der Anisotropiefaktor AF:

$$AF = \sigma_{MD}(125\%) / \sigma_{TD}(125\%) \quad \text{wenn } \sigma_{MD}(125\%) > \sigma_{TD}(125\%)$$

$$AF = \sigma_{TD}(125\%) / \sigma_{MD}(125\%) \quad \text{wenn } \sigma_{TD}(125\%) > \sigma_{MD}(125\%)$$

mit $\sigma_{MD}(125\%)$ = Zugdehnungsspannung in Extrusionsrichtung bei 125 % Dehnung
$\sigma_{TD}(125\%)$ = Zugdehnungsspannung quer zur Extrusionsrichtung bei 125 % Dehnung

Mit der vorliegenden Definition ist AF immer $\geq$ 1. Die Abweichung vom Idealwert 1 ist ein Maß für die Anisotropie des Flexodruckelements. Die Bestimmung der Zugdehnungsspannungen erfolgte mit einem Zugdehnungsmessgerät vom Typ Zwick Z2.5/TN1S (Zwick GmbH & Co. KG).

Das Flexodruckelement gilt für die Praxis als im wesentlichen isotrop, wenn der Anisotropiefaktor die Bedingung AF $\leq$ 1,2 erfüllt.

Verwendete Einsatzstoffe

Kraton® D-1192:    SBS-Blockcopolymer (Kraton Polymers) $M_w \approx$ 150.000 g/mol, 10 % SB-Diblock-Anteil, 30 % Styrol-, 42 % 1,4-Butadien-, 28 % 1,2-Butadieneinheiten

Kraton® D-4150:    SBS-Blockcopolymer mit 33% Paraffinöl (Kraton Polymers) $M_w \approx$ 170.000 g/mol, 17 % SB-Diblock-Anteil 31 % Styrol-, 62 % 1,4-Butadien-, 7 % 1,2-Butadieneinheiten

Kraton® D-1102:    SBS-Blockcopolymer (Kraton Polymers) $M_w \approx$ 125.000 g/mol, 17 % SB-Diblock-Anteil 30 % Styrol-, 63 % 1,4-Butadien-, 7 % 1,2-Butadieneinheiten

Kraton® D-1161:    SIS-Blockcopolymer (Kraton Polymers) $M_w$ = 210.000 g/mol, 17 % SB-Diblock-Anteil 15 % Styrol-, 78 % 1,4-Isopren-, 7 % 4,3-Isopreneinheiten

(fortgesetzt)

| | |
|---|---|
| Kraton® DX-1000: | SB-Blockcopolymer (Kraton Polymers) $M_w \approx 230.000$ g/mol, 100 % SB-Diblock-Anteil 9 % Styrol-, 84 % 1,4-Butadien-, 7 % 1,2-Butadieneinheiten |
| Nisso® PB B-1000 | Oligomeres Polybutadienöl (Nippon Soda) $M_N \approx 1.050$ g/mol, 15 % 1,4-Butadien-, 85 % 1,2-Butadieneinheiten |
| Lithene® PH | Oligomeres Polybutadienöl (Chemetall) $M_N \approx 2.600$ g/mol, 55 % 1,4-Butadien-, 45 % 1,2-Butadieneinheiten |
| Ondina® 934 | Medizinisches Weißöl (Shell) |
| Laromer® HDDA: | 1,6-Hexandioldiacrylat (BASF) |
| HDDMA: | 1,6-Hexandioldimethacrylat (Röhm GmbH & Co. KG) |
| Lucirin® BDK | Benzildimethylketal (BASF) |
| Kerobit® TBK | 2,6-Di-tert.-butyl-p-kresol (Raschig) |

Beispiel 1

Zunächst wurde in einem Diosna-Mischer (Typ V25 mit Zerhacker, Fa. Dierks & Söhne GmbH) ein Precompound aus 67 Gew.-% Kraton D-1192 und 33 Gew.-% Ondina 934 hergestellt. Dieser Compound aus vinylreichem SBS-Blockcopolymer und Mineralöl-Weichmacher wird als "Kraton D-1192-Compound" bezeichnet.

Nach dem oben beschriebenen Extrusionsverfahren wurde ein Flexodruckelement der folgenden Zusammensetzung / Struktur hergestellt:

| Beispiel 1 | | |
|---|---|---|
| **Zusammensetzung** | | |
| Kraton® D-1192-Compound | w.-% | 66,950 |
| Lithene® PH (*Weichmacher – 45 % Vinyl*) | w.-% | 20,000 |
| Laromer® HDDA | w.-% | 10,000 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| | | |
| **Berechnete Daten zur Zusammensetzung** | | |
| Summe Bindemittel bez. $\Sigma_{ges}$ | w.-% | 45 |
| Anteil Vinylgruppen Hauptbindemittel | w.-% | 28 |
| Summe Weichmacher bez. $\Sigma_{ges}$ | w.-% | 42 |
| Summe aller Vinylgruppen bez. $\Sigma_{ges}$ | w.-% | 22 |
| | | |
| **Komponenten des Schichtverbundes** | | |
| Träger | 175 $\mu m$ | *PET-Folie:* Melinex® 740 |
| Trägerbeschichtung | 7 $\mu m$ | Haftlack mit UV-Absorber |
| Fotopolymerisierbare Schicht | 980 $\mu m$ | *lt. Zusammensetzung* |
| Deckfolie | 125 $\mu m$ | *PET-Folie:* Lumirror® X 43 |
| Substrat Deckfolie | 3 $\mu m$ | Macromelt ®6900 + Joncryl ®586 |
| *Gesamtschichtdicke (mit Deckelement)* | *1290 $\mu m$* | |
| Klischee-Schichtdicke (ohne Deckelement) | 1140 $\mu m$ | |
| | | |
| Anisotropiefaktor AF | | 1,0 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert.

Beispiel 2

Analog Beispiel 1 wurde mittels Extrusionsverfahren ein Flexodruckelement der folgenden Zusammensetzung / Struktur hergestellt:

| Beispiel 2 | | |
|---|---|---|
| **Zusammensetzung** | | |
| Kraton® D-1192-Compound | w.-% | 56,950 |
| Kraton® DX-1000 (*Bindemittel 2*) | w.-% | 10,000 |
| Nisso® PB-B 1000 (*Weichmacher – 85 % Vinyl*) | w.-% | 20,000 |
| Laromer® HDDA | w.-% | 10,000 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| **Berechnete Daten zur Zusammensetzung** | | |
| Summe Bindemittel bez. $\Sigma_{ges}$ | w.-% | 48 |
| Anteil Vinylgruppen Hauptbindemittel | w.-% | 28 |
| Anteil Vinylgruppen Bindemittel 2 | w.-% | 7 |
| Summe Weichmacher bez. $\Sigma_{ges}$ | w.-% | 39 |
| Summe aller Vinylgruppen bez. $\Sigma_{ges}$ | w.-% | 28 |
| **Komponenten des Schichtverbundes** | | |
| Träger | 175 $\mu$m | *PET-Folie:* Melinex® 740 |
| Trägerbeschichtung | 7 $\mu$m | Haftlack mit UV-Absorber |
| Fotopolymerisierbare Schicht | 980 $\mu$m | *lt. Zusammensetzung* |
| Deckfolie | 125 $\mu$m | *PET-Folie:* Lumirror® X 43 |
| Substrat Deckfolie | 3 $\mu$m | Macromelt ®6900 + Joncryl ®586 |
| *Gesamtschichtdicke (mit Deckelement)* | *1290 $\mu$m* | |
| Klischee-Schichtdicke (ohne Deckelement) | 1140 $\mu$m | |
| **Anisotropiefaktor AF** | | 1,1 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert.

Beispiel V3 (Vergleichsbeispiel)

Zu hoher Bindemittelanteil

Analog Beispiel 1 wurde mittels Extrusionsverfahren ein Flexodruckelement der folgenden Zusammensetzung / Struktur hergestellt:

| Beispiel V3 (Vergleichsbeispiel) | | |
|---|---|---|
| **Zusammensetzung** | | |
| Kraton® D-1192-Compound | w.-% | 76,950 |
| Lithene® PH (*Weichmacher – 45 % Vinyl*) | w.-% | 10,000 |
| Laromer® HDDA | w.-% | 10,000 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| **Berechnete Daten zur Zusammensetzung** | | |
| Summe Bindemittel bez. $\Sigma_{ges}$ | w.-% | 52 |
| Anteil Vinylgruppen Hauptbindemittel | w.-% | 28 |
| Summe Weichmacher bez. $\Sigma_{ges}$ | w.-% | 36 |
| Summe aller Vinylgruppen bez. $\Sigma_{ges}$ | w.-% | 19 |
| **Komponenten des Schichtverbundes** | | |
| Träger | 175 µm | *PET-Folie:* Melinex® 740 |
| Trägerbeschichtung | 7 µm | Haftlack mit UV-Absorber |
| Fotopolymerisierbare Schicht | 980 µm | *lt. Zusammensetzung* |
| Deckfolie | 125 µm | *PET-Folie:* Lumirror® X 43 |
| Substrat Deckfolie | 3 µm | Macromelt ®6900 + Joncryl ®586 |
| *Gesamtschichtdicke (mit Deckelement)* | 1290 µm | |
| Klischee-Schichtdicke (ohne Deckelement) | 1140 µm | |
| **Anisotropiefaktor AF** | | 4,2 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert. Aufgrund des sehr hohen Anisotropiefaktors von 4,2 ist das Flexodruckelement für die Druckpraxis ungeeignet.

Beispiel V4 (Vergleichsbeispiel)

Zu hoher Bindemittelanteil

Analog Beispiel 1 wurde mittels Extrusionsverfahren ein Flexodruckelement der folgenden Zusammensetzung / Struktur hergestellt:

| Beispiel V4 (Vergleichsbeispiel) | | |
|---|---|---|
| **Zusammensetzung** | | |
| Kraton® D-1192-Compound | w.-% | 46,950 |
| Kraton® DX-1000 (*Bindemittel 2*) | w.-% | 20,000 |
| Lithene® PH (*Weichmacher – 45 % Vinyl*) | w.-% | 20,000 |
| Laromer® HDDA | w.-% | 10,000 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| **Berechnete Daten zur Zusammensetzung** | | |
| Summe Bindemittel bez. $\Sigma_{ges}$ | w.-% | 51 |
| Anteil Vinylgruppen Hauptbindemittel | w.-% | 28 |
| Anteil Vinylgruppen Bindemittel 2 | w.-% | 7 |
| Summe Weichmacher bez. $\Sigma_{ges}$ | w.-% | 36 |
| Summe aller Vinylgruppen bez. $\Sigma_{ges}$ | w.-% | 19 |
| **Komponenten des Schichtverbundes** | | |
| Träger | 175 µm | *PET-Folie:* Melinex® 740 |
| Trägerbeschichtung | 7 µm | Haftlack mit UV-Absorber |
| Fotopolymerisierbare Schicht | 980 µm | *lt. Zusammensetzung* |
| Deckfolie | 125 µm | *PET-Folie:* Lumirror® X 43 |
| Substrat Deckfolie | 3 µm | Macromelt ®6900 + Joncryl ®586 |
| *Gesamtschichtdicke (mit Deckelement)* | *1290 µm* | |
| Klischee-Schichtdicke (ohne Deckelement) | 1140 µm | |
| Anisotropiefaktor AF | | 1,4 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert. Aufgrund des Anisotropiefaktors von 1,4 ist das Flexodruckelement für die Druckpraxis weniger geeignet.

Beispiel V5 (Vergleichsbeispiel)

Zu geringer Vinylanteil

Analog Beispiel 1 wurde mittels Extrusionsverfahren ein Flexodruckelement der folgenden Zusammensetzung / Struktur hergestellt:

| Beispiel V5 (Vergleichsbeispiel) | | |
|---|---|---|
| **Zusammensetzung** | | |
| Kraton® D-4150 (33% Mineralöl) | w.-% | 56,950 |
| Kraton® DX-1000 (*Bindemittel 2*) | w.-% | 10,000 |
| Lithene® PH (*Weichmacher – 45 % Vinyl*) | w.-% | 20,000 |
| Laromer® HDDA | w.-% | 10,000 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| **Berechnete Daten zur Zusammensetzung** | | |
| Summe Bindemittel bez. $\Sigma_{ges}$ | w.-% | 48 |
| Anteil Vinylgruppen Hauptbindemittel | w.-% | 7 |
| Anteil Vinylgruppen Bindemittel 2 | w.-% | 7 |
| Summe Weichmacher bez. $\Sigma_{ges}$ | w.-% | 39 |
| Summe aller Vinylgruppen bez. $\Sigma_{ges}$ | w.-% | 12 |
| **Komponenten des Schichtverbundes** | | |
| Träger | 175 $\mu m$ | *PET-Folie:* Melinex® 740 |
| Trägerbeschichtung | 7 $\mu m$ | Haftlack mit UV-Absorber |
| Fotopolymerisierbare Schicht | 980 $\mu m$ | *lt. Zusammensetzung* |
| Deckfolie | 125 $\mu m$ | *PET-Folie:* Lumirror® X 43 |
| Substrat Deckfolie | 3 $\mu m$ | Macromelt ®6900 + Joncryl ®586 |
| *Gesamtschichtdicke (mit Deckelement)* | 1290 $\mu m$ | |
| Klischee-Schichtdicke (ohne Deckelement) | 1140 $\mu m$ | |
| Anisotropiefaktor AF | | 1,1 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert.

Beispiel V6 (Vergleichsbeispiel)

Zu hoher Bindemittelanteil

Analog Beispiel 1 wurde mittels Extrusionsverfahren ein Flexodruckelement der folgenden Zusammensetzung / Struktur hergestellt:

| Beispiel V6 (Vergleichsbeispiel) | | |
|---|---|---|
| **Zusammensetzung** | | |
| Kraton® D-1102 | w.-% | 54,950 |
| Lithene® PH (*Weichmacher – 45 % Vinyl*) | w.-% | 32,000 |
| Laromer® HDDA | w.-% | 10,000 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| **Berechnete Daten zur Zusammensetzung** | | |
| Summe Bindemittel bez. $\Sigma_{ges}$ | w.-% | 55 |
| Anteil Vinylgruppen Hauptbindemittel | w.-% | 7 |
| Summe Weichmacher bez. $\Sigma_{ges}$ | w.-% | 32 |
| Summe aller Vinylgruppen bez. $\Sigma_{ges}$ | w.-% | 18 |
| **Komponenten des Schichtverbundes** | | |
| Träger | 175 $\mu$m | PET-Folie: Melinex® 740 |
| Trägerbeschichtung | 7 $\mu$m | Haftlack mit UV-Absorber |
| Fotopolymerisierbare Schicht | 980 $\mu$m | lt. Zusammensetzung |
| Deckfolie | 125 $\mu$m | PET-Folie: Lumirror® X 43 |
| Substrat Deckfolie | 3 $\mu$m | Macromelt ®6900 + Joncryl ®586 |
| *Gesamtschichtdicke (mit Deckelement)* | 1290 $\mu$m | |
| Klischee-Schichtdicke (ohne Deckelement) | 1140 $\mu$m | |
| Anisotropiefaktor AF | | 1,0 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert.

Beispiel V7 (Vergleichsbeispiel)

Bindemittel auf Basis SIS

Analog Beispiel 1 wurde mittels Extrusionsverfahren ein Flexodruckelement der folgenden Zusammensetzung / Struktur hergestellt:

| Beispiel V7 (Vergleichsbeispiel) | | |
|---|---|---|
| **Zusammensetzung** | | |
| Kraton® D-1161 (*SIS-Blockcopolymer*) | w.-% | 71,950 |
| Nisso® PB-B 1000 (*Weichmacher – 85 % Vinyl*) | w.-% | 10,000 |
| Laromer® HDDA | w.-% | 7,500 |
| HDDMA | w.-% | 7,500 |
| Lucirin® BDK | w.-% | 2,000 |
| Kerobit® TBK | w.-% | 1,000 |
| Farbstoffe | w.-% | 0,050 |
| *Summe der Einsatzstoffe ($\Sigma_{ges}$)* | w.-% | 100,000 |
| | | |
| **Berechnete Daten zur Zusammensetzung** | | |
| Summe Bindemittel bez. $\Sigma_{ges}$ | w.-% | 72 |
| Anteil Vinylgruppen Hauptbindemittel | w.-% | 7 |
| Summe Weichmacher bez. $\Sigma_{ges}$ | w.-% | 10 |
| Summe aller Vinylgruppen bez. $\Sigma_{ges}$ | w.-% | 14 |
| | | |
| **Komponenten des Schichtverbundes** | | |
| Träger | 175 $\mu$m | *PET-Folie:* Melinex® 740 |
| Trägerbeschichtung | 7 $\mu$m | Haftlack mit UV-Absorber |
| Fotopolymerisierbare Schicht | 980 $\mu$m | *lt. Zusammensetzung* |
| Deckfolie | 125 $\mu$m | *PET-Folie:* Lumirror® X 43 |
| Substrat Deckfolie | 3 $\mu$m | Macromelt ®6900 + Joncryl ®586 |
| *Gesamtschichtdicke (mit Deckelement)* | 1290 $\mu$m | |
| Klischee-Schichtdicke (ohne Deckelement) | 1140 $\mu$m | |
| | | |
| Anisotropiefaktor AF | | 1,0 |

Der erhaltene Schichtverbund wurde in mind. 10 Platten des Formats 60 x 40 cm konfektioniert und vor der weiteren Verarbeitung 1 Woche bei 22°C unter Ausschluss von Licht gelagert.

Beispiel 1-A

Das Flexodruckelement aus Beispiel 1 wurde nach der nach dem Stand der Technik üblichen Methode eingetestet, um die optimale Auswaschgeschwindigkeit und vollflächige Vorbelichtungszeit zu ermitteln.

Hierzu wurden ca. 20 x 10 cm große Stücke des Flexodruckelements zunächst ohne Vorbelichtung bei verschiedenen Auswaschgeschwindigkeiten mit Hilfe des Auswaschgerätes in der Entwicklerflüssigkeit ausgewaschen und anschließend getrocknet.

Es wurde diejenige Auswaschgeschwindigkeit $v_{opt}$ (in mm / min) bestimmt, bei der die Relieftiefe 800 $\mu$m beträgt. Dies entspricht bei einer Druckplattenstärke von 1140 $\mu$m der allgemein geforderten Relieftiefe von ca. 700 $\mu$m zuzüglich 10 $\mu$m Sicherheitsabstand.

Anschließend wurde ein neues Klischee der zu prüfenden Platte hergestellt, bei dem in Felder unterteilt rückseitig mit zunehmenden Belichtungszeiten vorbelichtet wurde. Die zur Auswertung dienenden Vorbelichtungszeiten und deren Anordnung auf der zu prüfenden Druckplatte sind in der folgenden Zeichnung dargestellt.

| 120 s | 60 s | 40 s | 30 s | 0 s | 5s | 10 s | 15 s | 20 s |
|---|---|---|---|---|---|---|---|---|

Nach dem Auswaschen der vorbelichteten Druckplatte in der Entwicklerflüssigkeit und dem Trocknen bis zum Erreichen der Sollschichtdicke von 1140 µm wurde anhand einer Auftragung der Relieftiefe gegen die Vorbelichtungszeit diejenige Vorbelichtungszeit ermittelt, bei welcher die gewünschte Relieftiefe von 700 µm erreicht ist.

Mit den auf diese Weise ermittelten Werten für Vorbelichtungszeit und Auswaschgeschwindigkeit wurde das Flexodruckelement aus Beispiel 1 mit Hilfe eines Testnegatives wie weiter oben beschrieben vorbelichtet, bildmäßig belichtet, ausgewaschen, getrocknet und mittels der Prüfkriterien beurteilt.

Beispiele 2-A und Vergleichbeispiele V3-A bis V7-A

Analog Beispiel 1-A wurden die Flexodruckelemente aus Beispiel 2 und den Vergleichsbeispielen V3 bis V7 mit Hilfe von Testnegativen bildmäßig belichtet, ausgewaschen, getrocknet und bewertet. Die Ergebnisse der Beurteilung sind für alle Beispiele und Vergleichsbeispiele in der folgenden Tabelle 1 aufgelistet.

| Beispiel Nr. | | 1 | 2 | V3 | V4 | V5 | V6 | V7 |
|---|---|---|---|---|---|---|---|---|
| Daten zur Zusammensetzung | | | | | | | | |
| Hauptbindemittel | | v-SBS | v-SBS | v-SBS | v-SBS | SBS | SBS | SIS |
| Summe Bindemittel | w.-% | 45 | 48 | 52 | 51 | 48 | 55 | 72 |
| Anteil Vinylgruppen Hauptbindemittel | w.-% | 28 | 28 | 28 | 28 | 7 | 7 | 7 |
| Anteil Vinylgruppen Bindemittel 2 | w.-% | | 7 | | 7 | 7 | | |
| Summe Weichmacher | w.-% | 42 | 39 | 36 | 36 | 39 | 32 | 10 |
| Summe aller Vinylgruppen | w.-% | 22 | 28 | 19 | 19 | 12 | 18 | 14 |
| Anisotropiefaktor AF | | 1,0 | 1,1 | 4,2 | 1,4 | 1,1 | 1,0 | 1,0 |
| Entwicklung mittels Entwicklerflüssigkeit: Beispiel Nr. | | 1-A | 2-A | V3-A | V4-A | V5-A | V6-A | V7-A |
| Vorbelichtungszeit | sec | 15 | 15 | 15 | 15 | 15 | 20 | 20 |
| Auswaschgeschwindigkeit | mm / min | 140 | 140 | 140 | 140 | 140 | 160 | 120 |
| Nachbelichtungszeit UVA | min | 10 | 10 | 10 | 10 | 10 | 10 | 10 |
| Nachbelichtungszeit UVC | min | 20 | 20 | 20 | 20 | 20 | 20 | 20 |
| Relieftiefe | µm | 730 | 710 | 760 | 700 | 740 | 670 | 680 |
| Mechanische Härte (DIN 53505) | °Shore A | 50 | 61 | 66 | 56 | 45 | 63 | |
| UBG (LEL) | min | 8 | 8 | 6 | 8 | 10 | 8 | 10 |
| OBG (UEL) | min | >18 | >18 | >18 | >18 | >18 | >18 | >18 |
| BSPR (exposure latitude) | min | > +10 | > +10 | > +12 | > +10 | > +8 | > +10 | > +8 |

Tabelle 1: Zusammenstellung Ergebnisse aus Beispielen und Vergleichsbeispielen bei Entwicklung mittels einer Entwicklerflüssigkeit

Beispiele 1-B, 2-B und Vergleichbeispiele V3-B bis V7-B

Die Flexodruckelemente aus den Beispielen 1 und 2 sowie den Vergleichsbeispielen V3 bis V7 wurden wie weiter oben beschrieben thermisch verarbeitet. Die verwendeten Verarbeitungsparameter und Ergebnisse der Beurteilung sind für alle Beispiele in der folgenden Tabelle 2 dargestellt.

| Beispiel Nr. | | 1 | 2 | V3 | V4 | V5 | V6 | V7 |
|---|---|---|---|---|---|---|---|---|
| Daten zur Zusammensetzung | | | | | | | | |
| Hauptbindemittel | | v-SBS | v-SBS | v-SBS | v-SBS | SBS | SBS | SIS |
| Summe Bindemittel | w.-% | 45 | 48 | 52 | 51 | 48 | 55 | 72 |
| Anteil Vinylgruppen Hauptbindemittel | w.-% | 28 | 28 | 28 | 28 | 7 | 7 | 7 |
| Anteil Vinylgruppen Bindemittel 2 | w.-% | | 7 | | 7 | 7 | | |
| Summe Weichmacher | w.-% | 42 | 39 | 36 | 36 | 39 | 32 | 10 |
| Summe aller Vinylgruppen | w.-% | 22 | 28 | 19 | 19 | 12 | 18 | 14 |
| Anisotropiefaktor AF | | 1,0 | 1,1 | 4,2 | 1,4 | 1,1 | 1,0 | 1,0 |
| Thermische Entwicklung: Beispiel Nr. | | 1-B | 2-B | V3-B | V4-B | V5-B | V6-B | V7-B |
| Vorbelichtungszeit | sec | 15 | 15 | 15 | 15 | 15 | 20 | 20 |
| Anzahl Verarbeitungszyklen | | 10 | 10 | 10 | 10 | 10 | 10 | 10 |
| Temperatur Heizwalze | °C | 163 | 163 | 163 | 163 | 163 | 163 | 163 |
| Nachbelichtungszeit UVA | min | 10 | 10 | 10 | 10 | 10 | 10 | 10 |
| Nachbelichtungszeit UVC | min | 20 | 20 | 20 | 20 | 20 | 20 | 20 |
| Relieftiefe | $\mu$m | 630 | 570 | 510 | 390 | 580 | 770 | 530 |
| Mechanische Härte (DIN 53505) | °Shore A | 50 | 61 | 66 | 56 | 45 | 63 | |
| UBG (LEL) | min | 8 | 10 | 8 | 8 | > 18 | > 18 | 10 |
| OBG (UEL) | min | 10 | 10 | 4 | 2 | 8 | 10 | 2 |
| BSPR (exposure latitude) | min | +2 | 0 | -4 | -6 | < -10 | < -8 | -8 |

**Tabelle 2: Zusammenstellung Ergebnisse aus Beispielen und Vergleichsbeispielen bei thermischer Entwicklung.**

Wie man Tabelle 1 entnehmen kann, sind alle Flexodruckelemente für die konventionelle Verarbeitung mit Entwicklerflüssigkeiten geeignet. Man erhält bei vergleichbaren verarbeitungsbedingungen Flexodruckelemente, die einen ausreichend großen Belichtungsspielraum aufweisen.

Bei der thermischen Verarbeitung (siehe Tabelle 2) liefern jedoch nur die erfindungsgemäßen Flexodruckelemente Druckklischees mit einem Belichtungsspielraum ≥ 0. Solche Flexodruckelemente können nach der bildmäßigen Belichtung unproblematisch thermisch entwickelt werden. Bei den Vergleichsbeispielen ist der Belichtungsspielraum negativ. Dies bedeutet, dass solche Flexodruckelemente bei Belichtungszeiten, die für die korrekte Ausbildung von Positivelementen notwendig sind, bereits verminderte Relieftiefen in Negativelementen aufweisen. Dies führt im Druck zu einem schnellen Zusetzen mit Druckfarbe und damit insbesondere bei höheren Auflagen zu einem minderqualitativen, verwaschenen Druckbild und einer höheren Tonwertzunahme. Mitunter muss der Druckprozess unterbrochen und die Platte gereinigt werden.

Bei den Vergleichbeispielen V5-B und V6-B war sogar innerhalb einer bildmäßigen Belichtungszeit von 18 Minuten keine korrekte Ausbildung der Positivelemente möglich. Im Druck führen solche Druckformen zu unsauberen, minderqualitativen Druckergebissen mit Ausbrüchen im Druckbild, speziell bei Rastern im niedrigen Tonwertbereich und feinen Linienelementen wie z.B. kleinen Schriften.

V7-B zeigt, dass mit einer SIS-Platte kein positiver Belichtungsspielraum erhalten werden konnte.

**Patentansprüche**

1.   Verfahren zur Herstellung von Flexodruckformen durch thermische Entwicklung, bei dem man als Ausgangsmaterial ein fotopolymerisierbares Flexodruckelement einsetzt, welches übereinander angeordnet mindestens umfasst

- einen dimensionsstabilen Träger,
- mindestens eine fotopolymerisierbare reliefbildende Schicht, mindestens umfassend ein elastomeres Bindemittel, ethylenisch ungesättigte Monomere, Weichmacher und Fotoinitiator,

und das Verfahren mindestens die folgenden Schritte umfasst:

(a) bildweises Belichten der fotopolymerisierbaren reliefbildenden Schicht mittels aktinischer Strahlung,
(b) Erwärmen des belichteten Flexodruckelementes auf eine Temperatur von 40 bis 200°C,
(c) Entfernen der erweichten, nicht polymerisierten Anteile der reliefbildenden Schicht unter Ausbildung eines Druckreliefs,

**dadurch gekennzeichnet, dass** es sich bei dem elastomeren Bindemittel um mindestens ein Styrol-Butadien-Blockcopolymeres mit einem Molekulargewicht $M_w$ von 80 000 bis 250 000 g/mol und einem Styrolgehalt von 15 bis 35 Gew. % bzgl. des Bindemittels handelt, wobei der Anteil von Butadien, welches 1,2-verknüpft vorliegt, mindestens 15 Gew. % bzgl. des Bindemittels beträgt, und die Menge des Styrol-Butadien-Blockcopolymeren 35 bis 50 Gew. % und die des Weichmachers 25 bis 50 Gew. % jeweils bezüglich der Summe aller Komponenten der reliefbildenden Schicht beträgt.

2. Verfahren gemäß Anspruch 1, **dadurch gekennzeichnet, dass** die Menge des Weichmachers 30 bis 45 Gew. % und die des Styrol-Butadien-Blockcopolymers 35 bis 50 Gew. %, jeweils bezüglich der Summe aller Komponenten der reliefbildenden Schicht beträgt.

3. Verfahren gemäß Anspruch 1 oder 2, **dadurch gekennzeichnet, dass** der Anteil des Butadiens, welches im Polymer 1,2-verknüpft vorliegt, mindestens 20 Gew. % bezüglich des Bindemittels beträgt.

4. Verfahren gemäß einem der Ansprüche 1 bis 3, **dadurch gekennzeichnet, dass** sich bei dem Weichmacher um ein Gemisch von Weichmachern handelt, welches mindestens ein Polybutadienöl umfasst.

5. Verfahren gemäß Anspruch 4, **dadurch gekennzeichnet, dass** das Weichmacher-Gemisch weiterhin mindestens ein Mineralöl umfasst.

6. Verfahren gemäß Anspruch 4 oder 5, **dadurch gekennzeichnet, dass** die Butadieneinheiten im Polybutadienöl zu mindestens 40 Gew. % 1,2-verknüpft eingebaut sind.

7. Verfahren gemäß einem der Ansprüche 1 oder 6, **dadurch gekennzeichnet, dass** die reliefbildende Schicht zusätzlich bis zu 20 Gew. % mindestens eines sekundären Bindemittels umfasst.

8. Verfahren gemäß einem der Ansprüche 1 bis 7, **dadurch gekennzeichnet, dass** man das bildweise Belichten (a) ausführt, indem man eine Maske auf das Flexodruckelement auflegt und durch die aufgelegte Maske hindurch belichtet.

9. Verfahren gemäß einem der Ansprüche 1 bis 7, **dadurch gekennzeichnet, dass** das Flexodruckelement zusätzlich eine digital bebilderbare Schicht aufweist und man Schritt (a) ausführt, indem man die digital bebilderbare Schicht bildmäßig beschreibt und durch die somit in situ erstellte Maske hindurch belichtet.

10. Verfahren gemäß Anspruch 9, **dadurch gekennzeichnet, dass** es sich bei der digital bebilderbaren Maske um eine Maske, ausgewählt aus der Gruppe von IR-ablativen Masken, Ink-Jet-Masken oder thermografischen Masken handelt.

11. Verfahren gemäß Anspruch 9 oder 10, **dadurch gekennzeichnet, dass** man die digital bebilderbare Schicht oder die Reste davon vor Verfahrensschritt (b) von der reliefbildenden Schicht ablöst.

12. Verfahren gemäß Anspruch 11, **dadurch gekennzeichnet, dass** die digital bebilderbare Schicht wasserlöslich ist und man die digital bebilderbare Schicht oder die Reste davon vor Schritt (b) mit Wasser oder einem überwiegend wässrigen Lösemittel ablöst.

13. Verfahren gemäß einem der Ansprüche 1 bis 12, **dadurch gekennzeichnet dass** man die Entfernung der erweichten, nicht polymerisierten Anteile durch Kontaktieren des Flexodruckelementes mit einem absorbierenden Material vornimmt.

14. Verfahren gemäß einem der Ansprüche 1 bis 12, **dadurch gekennzeichnet dass** man die Entfernung der erweichten, nicht polymerisierten Anteile durch Bearbeitung des Flexodruckelementes mit heißen Luft- oder Flüssigkeitsströmen unter Druck vornimmt.

15. Verfahren gemäß einem der Ansprüche 1 bis 14, **dadurch gekennzeichnet, dass** die Temperatur in Schritt (b) 60 bis 160°C beträgt.


**Claims**

1. Method for producing flexographic printing forms by thermal development, in which the starting material employed is a photopolymerizable flexographic printing element which comprises, arranged one above the other, at least

   • a dimensionally stable carrier,
   • at least one photopolymerizable relief-forming layer, comprising at least one elastomeric binder, ethylenically unsaturated monomer, plasticizer and photoinitiator,

   and the method comprises at least the following steps:

   (a) image-like exposure of the photopolymerizable relief-forming layer by means of actinic radiation,
   (b) heating of the exposed flexographic printing element to a temperature of from 40 to 200 °C,
   (c) removal of the softened, non-polymerized portions of the relief-forming layer to form a print relief,

   **characterized in that** the elastomeric binder is at least one styrene/butadiene block copolymer having a molecular weight $M_w$ of from 80,000 to 250,000 g/mol
   and a styrene content of from 15 to 35 wt.% with respect to the binder, wherein the content of butadiene which is in the 1,2-coupled form is at least 15 wt.% with respect to the binder, and the amount of the styrene/butadiene block copolymer is 35 to 50 wt.% and that of the plasticizer is 25 to 50 wt.%, in each case with respect to the sum of all the components of the relief-forming layer.

2. Method according to claim 1, **characterized in that** the amount of the plasticizer is 30 to 45 wt.% and that of the styrene/butadiene block copolymer is 35 to 50 wt.%, in each case with respect to the sum of all the components of the relief-forming layer.

3. Method according to claim 1 or 2, **characterized in that** the content of butadiene which is in the 1,2-coupled form in the polymer is at least 20 wt.% with respect to the binder.

4. Method according to one of claims 1 to 3, **characterized in that** the plasticizer is a mixture of plasticizers which comprises at least one polybutadiene oil.

5. Method according to claim 4, **characterized in that** the plasticizer mixture furthermore comprises at least one mineral oil.

6. Method according to claim 4 or 5, **characterized in that** the butadiene units in the polybutadiene oil are incorporated in the 1,2-coupled form to the extent of at least 40 wt.%.

7. Method according to one of claims 1 or 6, **characterized in that** the relief-forming layer additionally comprises up to 20 wt.% of at least one secondary binder.

8. Method according to one of claims 1 to 7, **characterized in that** the image-like exposure (a) is carried out by a procedure in which a mask is laid on the flexographic printing element and the exposure is carried out through the mask which has been laid on.

9. Method according to one of claims 1 to 7, **characterized in that** the flexographic printing element additionally comprises a layer which can be imaged digitally and step (a) is carried out by a procedure in which the layer which can be imaged digitally is written on according to the image and the exposure is carried out through the mask thus established in situ.

**10.** Method according to claim 9, **characterized in that** the mask which can be imaged digitally is a mask chosen from the group of IR-ablative masks, ink-jet masks or thermographic masks.

**11.** Method according to claim 9 or 10, **characterized in that** the layer which can be imaged digitally or the residues thereof are detached from the relief-forming layer before method step (b).

**12.** Method according to claim 11, **characterized in that** the layer which can be imaged digitally is watersoluble and the layer which can be imaged digitally or the residues thereof are detached with water or a predominantly aqueous solvent before step (b).

**13.** Method according to one of claims 1 to 12, **characterized in that** the removal of the softened, non-polymerized portions is carried out by bringing the flexographic printing element into contact with an absorbent material.

**14.** Method according to one of claims 1 to 12, **characterized in that** the removal of the softened, non-polymerized portions is carried out by processing the flexographic printing elements with streams of hot air or liquid under pressure.

**15.** Method according to one of claims 1 to 14, **characterized in that** the temperature in step (b) is 60 to 160 °C.

**Revendications**

**1.** Procédé pour la fabrication de clichés flexographiques par développement thermique, dans lequel on met en oeuvre, à titre de matière de départ, un élément de cliché flexographique photopolymérisable qui comprend, à l'état superposé, au moins :

- un support résistant à la déformation ;
- au moins une couche photopolymérisable formant un relief, comprenant au moins un liant élastomère, des monomères à insaturation éthylénique, des plastifiants et des photoinitiateurs ;

et le procédé comprenant au moins les étapes suivantes dans lesquelles :

(a) on expose en forme d'image la couche photopolymérisable formant un relief, au moyen d'un rayonnement actinique ;
(b) on chauffe l'élément de cliché flexographique exposé, à une température de 40 à 200 °C ;
(c) on élimine les fractions ramollies, non polymérisées, de la couche formant un relief pour obtenir un relief d'impression ;

**caractérisé en ce que**, en ce qui concerne le liant élastomère, il s'agit d'un copolymère séquencé de styrène-butadiène possédant un poids moléculaire $M_w$ de 80.000 à 250.000 g/mol et une teneur en styrène de 15 à 35 % en poids rapportés au liant, la fraction du butadiène, qui est présent en étant soumis à une liaison 1,2, s'élève à au moins 15 % en poids rapportés au liant, et la quantité du copolymère séquencé de styrène-diène s'élève de 35 à 50 % en poids et celle du plastifiant s'élève de 25 à 50 % en poids, chaque fois rapportés à la somme de tous les composants de la couche formant le relief.

**2.** Procédé selon la revendication 1, **caractérisé en ce que** la quantité du plastifiant s'élève de 30 à 45 % en poids et celle du copolymère séquencé de styrène-butadiène s'élève de 35 à 50 % en poids, chaque fois rapportés à la somme de tous les composants de la couche formant le relief.

**3.** Procédé selon la revendication 1 ou 2, **caractérisé en ce que** la fraction du butadiène, qui est présent en étant soumis à une liaison 1,2, s'élève à au moins 20 % en poids rapportés au liant.

**4.** Procédé selon l'une quelconque des revendications 1 à 3, **caractérisé en ce qu'**il s'agit, en ce qui concerne le plastifiant, d'un mélange de plastifiants, qui comprend au moins un polybutadiénol.

**5.** Procédé selon la revendication 4, **caractérisé en ce que** le mélange de plastifiants comprend en outre au moins une huile minérale.

**6.** Procédé selon la revendication 4 ou 5, **caractérisé en ce que** les unités de butadiène dans le polybutadiénol sont incorporées à concurrence d'au moins 40 % en poids en étant soumis à une liaison 1,2.

**7.** Procédé selon l'une quelconque des revendications 1 ou 6, **caractérisé en ce que** la couche formant un relief comprend en outre au moins un liant secondaire jusqu'à concurrence de 20 % en poids.

**8.** Procédé selon l'une quelconque des revendications 1 à 7, **caractérisé en ce qu'**on effectue l'exposition (a) en forme d'image en appliquant un masque sur l'élément d'impression flexographique et en exposant à travers le masque appliqué.

**9.** Procédé selon l'une quelconque des revendications 1 à 7, **caractérisé en ce que** l'élément de cliché flexographique présente en outre une couche apte à porter une image par voie numérique et **en ce qu'**on met en oeuvre l'étape (a) en imprimant en forme d'image la couche apte à porter une image par voie numérique et en exposant à travers le masque ainsi obtenu in situ.

**10.** Procédé selon la revendication 9, **caractérisé en ce qu'**il s'agit, en ce qui concerne le masque apte à porter une image par voie numérique, d'un masque choisi parmi le groupe des masques aptes à subir une ablation par exposition au rayonnement infrarouge, des masques pour l'impression par jet d'encre ou des masques thermographiques.

**11.** Procédé selon la revendication 9 ou 10, **caractérisé en ce qu'**on sépare de la couche formant un relief, la couche apte à porter une image par voie numérique ou les résidus de ladite couche, avant l'étape opératoire (b).

**12.** Procédé selon la revendication 11, **caractérisé en ce que** la couche apte à porter une image par voie numérique est soluble dans l'eau et on sépare la couche apte à porter une image par voie numérique ou les résidus de ladite couche avant l'étape (b) avec de l'eau ou avec un solvant principalement aqueux.

**13.** Procédé selon l'une quelconque des revendications 1 à 12, **caractérisé en ce qu'**on procède à l'élimination des fractions ramollies, non polymérisées, par mise en contact de l'élément de cliché flexographique avec une matière absorbante.

**14.** Procédé selon l'une quelconque des revendications 1 à 12, **caractérisé en ce qu'**on procède à l'élimination des fractions ramollies, non polymérisées, par traitement de l'élément de cliché flexographique avec des courants de liquide ou d'air chauds sous pression.

**15.** Procédé selon l'une quelconque des revendications 1 à 14, **caractérisé en ce que** la température, à l'étape (b), s'élève de 60 à 160°C.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 525206 A
- US 3264103 A
- US 5175072 A
- WO 9614603 A
- WO 0188615 A
- EP 1239329 A
- WO 0190818 A
- EP 469735 A
- WO 0118604 A
- EP 468745 A

- EP 778297 A
- EP 654150 A
- EP 1069475 A
- EP 1072953 A
- EP 1070989 A
- EP 654151 A
- EP 1136254 A
- US 5259311 A
- EP 084851 B